Europäisches Patentamt

European Patent Office

Office européen des brevets

(19)

(11) **EP 1 488 917 A1**

(12) **EUROPEAN PATENT APPLICATION**
published in accordance with Art. 158(3) EPC

(43) Date of publication:
22.12.2004 Bulletin 2004/52

(51) Int Cl.⁷: **B32B 3/02**, H01M 10/40, H01G 9/155

(21) Application number: 03712865.9

(22) Date of filing: 24.03.2003

(86) International application number:
PCT/JP2003/003543

(87) International publication number:
WO 2003/080325 (02.10.2003 Gazette 2003/40)

(84) Designated Contracting States:
AT BE BG CH CY CZ DE DK EE ES FI FR GB GR
HU IE IT LI LU MC NL PT RO SE SI SK TR

(30) Priority: 26.03.2002 JP 2002086798

(71) Applicant: MATSUSHITA ELECTRIC INDUSTRIAL
CO., LTD.
Kadoma-shi, Osaka 571-8501 (JP)

(72) Inventors:
• HONDA, Kazuyoshi
Takatsuki-shi, Osaka 569-0056 (JP)
• TAKAI, Yoriko
Toyonaka-shi, Osaka 560-0002 (JP)

• OKAZAKI, Sadayuki
Katano-shi, Osaka 576-0054 (JP)
• INABA, Junichi
Toyonaka-shi, Osaka 560-0003 (JP)
• ITOH, Syuuji
Nara-shi, Nara 631-0001 (JP)
• HIGUCHI, Hiroshi
Kyotanabe-shi, Kyoto 610-0353 (JP)
• SAKAI, Hitoshi
Nagoya-shi, Aichi 455-0076 (JP)
• MINO, Shinji
Ibaraki-shi, Osaka 567-0036 (JP)

(74) Representative: VOSSIUS & PARTNER
Siebertstrasse 4
81675 München (DE)

(54) **THIN-FILM LAMINATED BODY, THIN-FILM CELL, CAPACITOR, AND METHOD AND EQUIPMENT FOR MANUFACTURING THIN-FILM LAMINATED BODY**

(57)     A thin film layered product is composed of at least two deposition units, each of which includes at least a first thin film layer and a second thin film layer. At least one of the first thin film layer and the second thin film layer in each of the at least two deposition units is laminated so as to have an area decreased in a direction from a lower layer toward an upper layer. Thus, the reliability of connection between layers can be improved, and when a protective layer is formed on side faces, the formability and adhesion strength can be improved.

FIG. 1

**Description**

TECHNICAL FIELD

The present invention relates to a thin film layered product, and a thin film battery and a capacitor using the same. Furthermore, the present invention relates to a method and apparatus for manufacturing the thin film layered product.

BACKGROUND ART

In this era of information and communication, batteries have been finding wider application, and the operations of various kinds of devices have been supported by high-performance batteries. Particularly, it has been requested that rapid innovation be made in the technology of a lithium-ion secondary battery in accordance with the fast-moving evolution of devices such as a mobile phone and the like.

Furthermore, devices have been used at much shorter distance from users, and thus a demand for safety with respect to batteries also has been too important to be ignored. JP 5(1993)-43465 U discloses a lithium secondary battery that is improved in safety.

Currently, most kinds of electronic devices have been formed into chips so as to be mounted on surfaces of printed circuit boards. However, the technology for forming batteries into chips has been slow in making advances, thereby becoming more likely to constitute a limitation on the design of devices. Further, in the field of mobile devices, there also has been a growing demand for sheet-like secondary batteries, particularly for use in devices in the form of cards. However, the above-mentioned lithium secondary battery disclosed in JP 5(1993)-43465 U is a so-called liquid-type secondary battery formed in the following manner. That is, a positive electrode, a separator and a negative electrode are laminated in this order, and a laminate thus obtained is wound to form a structure. Then, the structure is immersed in an electrolytic solution so as to form the secondary battery. The structure of such a liquid-type secondary battery has imposed a limit on the degree to which the secondary battery can be reduced in size and thickness.

As means for meeting these technological demands, solid electrolytes have been receiving much attention. By the use of solid electrolytes, logically, it has been more likely to be feasible to design batteries to meet demands that conventionally have been considered impossibilities. For example, by the use of solid electrolytes, it may become possible to form batteries into thin films. In this case, it is advantageous in securing a battery capacity that the batteries are formed so as to have a multilayer structure. Thus, a thin film layering technique is essential in developing secondary batteries using solid electrolytes.

Meanwhile, in the field of capacitors for electronic circuits, it also has been requested to reduce a series equivalent resistance and a series equivalent inductance in accordance with higher frequencies and lower voltages that have been used for devices. As a result, thin film multilayer capacitors have been increased further in importance as means for fulfilling this request.

In the fields other than the fields described above of, for example, various kinds of passive components and display elements, the thin film layering technique also is of importance. Particularly, it has been demanded that high-level realization of performance, quality, cost and the like be made at the same time.

While expectations for the thin film layering technique have been extremely high as described above, it has been difficult to meet the expectations fully at present because of the following problems:

First, reliability of connection between thin film layers cannot be secured sufficiently. By failure of connection between thin film layers, for example, the battery capacity of a secondary battery may be decreased, and the capacitance of a capacitor may be decreased.

Secondly, when a protective layer or the like is formed on an outer surface so that properties can be prevented from changing over time under usage conditions, the protective layer does not provide sufficient adhesion. As a result, reliability in long-term use cannot be secured.

DISCLOSURE OF THE INVENTION

The present invention has as its object to solve the above-mentioned problems with conventional thin film layered products. That is, it is an object of the present invention to provide a thin film layered product that has improved reliability of connection between layers. Further, it is another object of the present invention to provide a thin film layered product that allows another layer to be formed on side faces with excellent formability and adhesion strength. Furthermore, it is still another object of the present invention to provide a thin film battery and a capacitor that can achieve high quality and stable performance by using such a thin film layered product. Moreover, it is still another object of the present invention to provide a method and an apparatus for manufacturing a thin film layered product, which are suitable for the manufacturing of the above-described thin film layered products.

**EP 1 488 917 A1**

In order to achieve the above-mentioned objects, the present invention has the following configurations.

A thin film layered product according to the present invention is composed of at least two deposition units, each of which includes at least a first thin film layer and a second thin film layer. At least one of the first thin film layer and the second thin film layer in each of the at least two deposition units has an area decreased in a direction from a lower layer toward an upper layer. According to this configuration, a thin film layered product can be provided that has improved reliability of connection between layers.

Preferably, the above-described thin film layered product has substantially the shape of a trapezoid in cross section along a layering direction. According to this configuration, another layer formed on side faces can be improved in formability and adhesion strength.

Next, a thin film battery according to the present invention is composed of at least two deposition units, each of which includes at least a current collector layer, a positive active material layer, a solid electrolyte layer, and a negative active material layer. At least one of the current collector layer, the positive active material layer, the solid electrolyte layer, and the negative active material layer in each of the at least two deposition units has an area decreased in a direction from a lower layer toward an upper layer. According to this configuration, a thin film battery can be provided that has improved reliability of connection between layers, thereby achieving stable quality.

Furthermore, a capacitor according to the present invention is composed of at least two deposition units, each of which includes at least a dielectric layer and an electrode layer. At least one of the dielectric layer and the electrode layer in each of the at least two deposition units has an area decreased in a direction from a lower layer toward an upper layer. According to this configuration, a capacitor can be provided that has improved reliability of connection between layers, thereby achieving stable quality.

Next, a method for manufacturing a thin film layered product according to the present invention includes by taking as one unit: a step of laminating a first thin film layer patterned into a predetermined shape; and a step of laminating a second thin film layer patterned into a predetermined shape. In the method, the unit of steps is performed repeatedly on a carrier, whereby the thin film layered product can be manufactured that is composed of at least two deposition units, each of which includes at least the first thin film layer and the second thin film layer. At least one of the first thin film layer and the second thin film layer in each of the at least two deposition units is laminated so as to have an area decreased with an increasing number of times the lamination is carried out.

Furthermore, an apparatus for manufacturing a thin film layered product according to the present invention includes a rotating carrier, a first thin film layer forming device that is opposed to the carrier and allows a material of a first thin film layer to be deposited on a surface of the carrier, a second thin film layer forming device that is opposed to the carrier and allows a material of a second thin film layer to be deposited on the surface of the carrier, and a patterning device that is opposed to the carrier and patterns each of the first thin film layer and the second thin film layer into a predetermined shape. The patterning device performs patterning with respect to at least one of the first thin film layer and the second thin film layer so that the at least one of the first thin film layer and the second thin film layer has an area decreased with an increasing number of rotations of the carrier.

According to the above-mentioned method and apparatus for manufacturing a thin film layered product according to the present invention, a thin film layered product can be provided that has improved reliability of connection between layers.

BRIEF DESCRIPTION OF THE DRAWINGS

FIG. 1 is a schematic cross sectional view showing a configuration of a thin film layered product according to Embodiment 1 of the present invention.

FIG. 2 is a cross sectional view showing an example in which a protective layer is formed on side faces of the thin film layered product shown in FIG.1.

FIG. 3 is a schematic cross sectional view showing a configuration of an example of an apparatus for manufacturing the thin film layered product shown in FIG. 1.

FIGs. 4A and 4B are schematic diagrams for showing a configuration of a patterning material application device used in the manufacturing apparatus shown in FIG. 3. FIG. 4A is a front view as seen from a side of a can roller, and FIG. 4B is a cross sectional view taken on line 4B - 4B of FIG. 4A.

FIG. 5 is a development drawing of an example of a stripe pattern of a patterning material formed on an outer peripheral surface of the can roller by a pair of the patterning material application devices.

FIG. 6A is a schematic cross sectional view showing a configuration of a thin film layered product according to Embodiment 3 of the present invention, and FIG. 6B is a schematic cross sectional view showing a configuration of a capacitor using the thin film layered product shown in FIG. 6A.

FIG. 7 is a cross sectional view showing an example of a secondary battery using a thin film layered product studied for the completion of the present invention.

3

BEST MODE FOR CARRYING OUT THE INVENTION

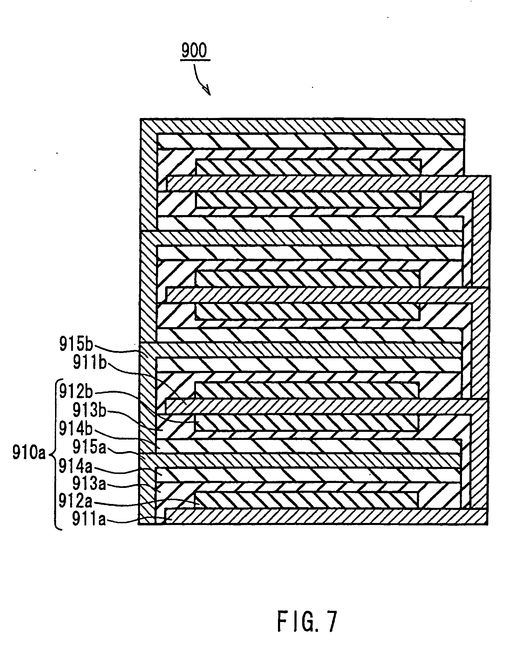

The inventors of the present invention manufactured a secondary battery using a solid electrolyte shown in FIG. 7 to study problems with the secondary battery. The secondary battery had a structure of a thin film layered product.

FIG. 7 is a schematic cross sectional view in a thickness direction showing a configuration of a thin film battery used for the study. As shown in the figure, a thin film battery 900 includes a deposition unit 910a in a lowest portion thereof. The deposition unit 910a includes a positive current collector layer 911a, a positive active material layer 912a, a solid electrolyte layer 913a, a negative active material layer 914a, a negative current collector layer 915a, a negative active material layer 914b, a solid electrolyte layer 913b, and a positive active material layer 912b, which are provided in this order from bottom to top. The thin film battery 900 is composed of a plurality of deposition units, each of which has the same configuration as the configuration described above with regard to the deposition unit 910a. The thin film battery 900 having this configuration as a whole has, for example, substantially the shape of a rectangular solid.

Layers having the same function while being laminated in different positions from each other are shown to have the same reference numeral with different subscripts from each other. For example, the positive current collector layer 911a and the positive current collector layer 911b, which are laminated in different positions from each other while having substantially the same function, are shown to have different subscripts so that they are distinguished from each other. However, in the following description, where there is no particular need for the distinction between the layers by their positions, the layers are shown without subscripts. For example, "the positive current collector layer 911" represents all of the positive current collector layers regardless of where the layers are laminated.

As shown in the figure, each of the layers is formed into a predetermined shape by patterning. Furthermore, the positive current collector layers 911 included respectively in each deposition unit are connected electrically to each other on one side face of the thin film battery 900. Similarly, the negative current collector layers 915 are connected electrically to each other on the other side face of the thin film battery 900. The positive current collector layers 911 and the negative current collector layers 915 are used as extraction electrodes, thereby allowing the thin film battery 900 to function as the secondary battery.

However, according to the result of the test performed by the inventors of the present invention, in the thin film battery 900 having the above-described configuration, although it is required essentially that electrical connection be established between the positive current collector layers 911 and between the negative current collector layers 915, in some cased, only insufficient connection was attained between these layers. This may decrease the battery capacity.

Furthermore, the side faces of the thin film battery 900 (surfaces parallel to a vertical direction on the plane of FIG. 7) are weak mechanically and chemically, and thus it is desirable that some form of a protective layer be provided on the side faces. However, in forming a thin film such as a protective layer on the side faces, a strong thin film hardly can be formed uniformly on the side faces, which has been disadvantageous.

This problem also may arise similarly in thin film layered products other than the thin film battery 900.

The inventors of the present invention made vigorous studies for the resolution of the above-mentioned problems with thin film layered products, which led them to the completion of the present invention.

That is, in a configuration including groups of various types of thin film layers, at least one of the various types of thin film layers is laminated so as to have an area decreased in a direction from a lower layer toward an upper layer. According to this configuration, the reliability of connection between the layers can be improved.

Hereinafter, the present invention will be described in detail with reference to the appended drawings.

(Embodiment 1)

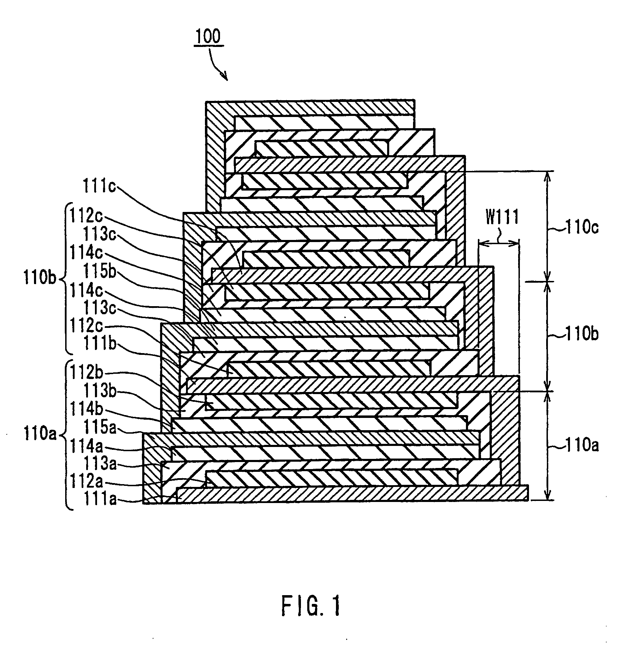

FIG. 1 is a schematic cross sectional view showing a configuration of a thin film layered product according to Embodiment 1 of the present invention. A thin film layered product 100 shown in FIG. 1 is used as a thin film battery.

As shown in the figure, the thin film layered product 100 according to this embodiment includes a deposition unit 110a in a lowest portion thereof. The deposition unit 110a includes a positive current collector layer 111a, a positive active material layer 112a, a solid electrolyte layer 113a, a negative active material layer 114a, a negative current collector layer 115a, a negative active material layer 114b, a solid electrolyte layer 113b, and a positive active material layer 112b, which are provided in this order from bottom to top. The thin film layered product 100 is composed of deposition units 110b, 110c and the like, each of which has the same configuration as the configuration described above with regard to the deposition unit 110a. Each of the layers is substantially rectangular in plan shape (shape of each layer as viewed from a layering direction (vertical direction on the plane of FIG. 1)).

Layers having the same function while being laminated in different positions from each other are shown to have the same reference numeral with different subscripts from each other. For example, the positive current collector layer 111a and the positive current collector layer 111b, which are laminated in different positions from each other while having substantially the same function, are shown to have different subscripts so that they are distinguished from each other. However, in the following description, where there is no particular need for the distinction between the layers by their positions, the layers are shown without subscripts. For example, "the positive current collector layer 111"represents all of the positive current collector layers regardless of where the layers are laminated.

Each of the layers is formed so as to have a predetermined rectangular plan shape by pattering. Furthermore, the positive current collector layers 111 are connected electrically to each other on one side face of the thin film layered product 100. Similarly, the negative current collector layers 115 are connected electrically to each other on the other side face of the thin layered product 100. The positive current collector layers 111 and the negative current collector layers 115 are used as extraction electrodes, thereby allowing the thin film layered product 100 to function as a thin film battery (secondary battery).

At least one of the groups of layers having the same function that constitute the thin film layered product 100 according to this embodiment are laminated so as to have an area (projected area of the at least one of the groups of layers along a layering direction) decreased in a direction from a lower layer toward an upper layer. That is, as for the positive current collector layers 111, a positive current collector layer 111b included in the deposition unit 110b on the deposition unit 110a has a lamination area smaller than a lamination area of the positive current collector layer 111a included in the deposition unit 110a. Further, a positive current collector layer 111c included in the deposition unit 110c on the deposition unit 110b has a lamination area smaller than the lamination area of the positive current collector layer 111b. The same applies to the negative current collector layers 115.

Furthermore, as for the solid electrolyte layers 113, a solid electrolyte layer 113b positioned above the solid electrolyte layer 113a positioned in a lowest portion has a formation area smaller than a formation area of the solid electrolyte layer 113a. Further, a solid electrolyte layer 113c positioned above the solid electrolyte layer 113b has a formation area smaller than the formation area of the solid electrolyte layer 113b. The same applies to the positive active material layers 112 and the negative active material layers 114.

As described above, each of the layers has a lamination area decreased in a direction from the lower layer toward the upper layer, so that step heights substantially in the form of steps are formed on the side faces of the thin film layered product 100. Further, macroscopically, the thin film layered product 100 has substantially the shape of a trapezoid in cross section along the layering direction.

According to this configuration, the following effect can be achieved.

First, as for the electrical connection between the positive current collector layers 111 and between the negative current collector layers 115 that is established on the side faces of the thin film layered product 100, the reliability of the connection can be improved. For example, the solid electrolyte layer 113c laminated above the solid electrolyte layer 113b has a lamination area smaller than the lamination area of the solid electrolyte layer 113b, so that an area of a region on an upper face of the positive current collector layer 111b in which the solid electrolyte layer 113c is not laminated is increased. That is, in FIG.1, a gap width W111 of the positive current collector layer 111b from an end portion of the solid electrolyte layer 113c is increased. Since the positive current collector layer 111c is connected electrically to the positive current collector layer 111b within this gap width W111, an increase in the gap width W111 allows electrical connection to be secured between the positive current collector layer 111b and the positive current collector layer 111c. Thus, the reliability of the electrical connection between a plurality of the positive current collector layers 111 that are laminated vertically can be improved. The same applies to the negative current collector layers 115.

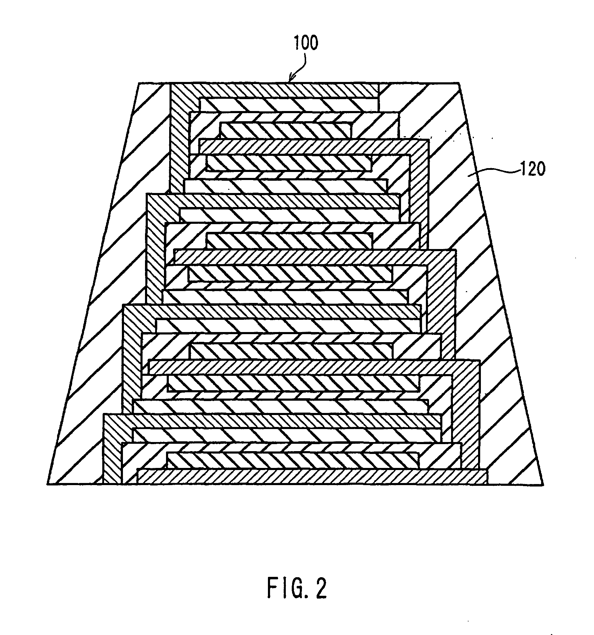

Secondly, in the case where a protective layer or the like is formed on the side faces, the formability and adhesion strength of the layer can be improved. FIG. 2 is a cross sectional view of an example in which a protective layer 120 is formed on the side faces of the thin film layered product 100 shown in FIG. 1. In some cases, after the thin film layered product 100 is formed, the protective layer 120 is formed by, for example, vapor deposition with respect to the thin film layered product 100 with an upper face masked. Macroscopically, the thin film layered product 100 according to this embodiment has the inclined side faces. Therefore, a material used for the vapor deposition, which is applied from an upper side on the plane of FIG. 2, adheres to the side faces easily. Further, since the side faces have the step heights in the form of steps, a surface area of the side face is increased, so that the adhesion area for the protective layer 120 to the side face can be increased. Thus, the formability and adhesion strength of the protective layer can be improved.

Preferably, the protective layer 120 is formed for the purposes of, for example, mechanically protecting the side faces of the thin film layered product 100 and improving moisture resistance. The protective layer 120 can be formed by a wet process such as coating, dipping (immersion), spraying or the like and a dry process such as vapor deposition, sputtering or the like. In the case where a protective layer is provided so that an inner portion of the thin film layered product 100 can be prevented from being deteriorated by water entry, it is effective to form a layer having low moisture permeability on the side faces. Such a protective layer can be formed of a thin film of a metal, a metal oxide, a metal nitride or a composite film formed as a combination of these films and a resin thin film. In the case of using a composite film as a protective layer, a stress that is generated inside a lower layer when a thin film as the lower layer is formed can be relieved when an upper layer is formed for the thin film. This allows a mechanical defect such as peeling, a crack or the like to be prevented from being caused in the protective layer as an end product. Further, even when pinholes exist in the composite film, a longer path of the pinholes as a whole is formed, thereby allowing moisture resistance to be increased.

In this embodiment, although there is no particular limit to the number of the deposition units 110b, 110c and the like, the number is preferably 3 or higher, more preferably 10 or higher, most preferably 30 or higher so that a compact and high-capacity thin film battery can be provided.

(Embodiment 2)

The description is directed to a method for manufacturing the thin film layered product 100 described with regard to Embodiment 1.

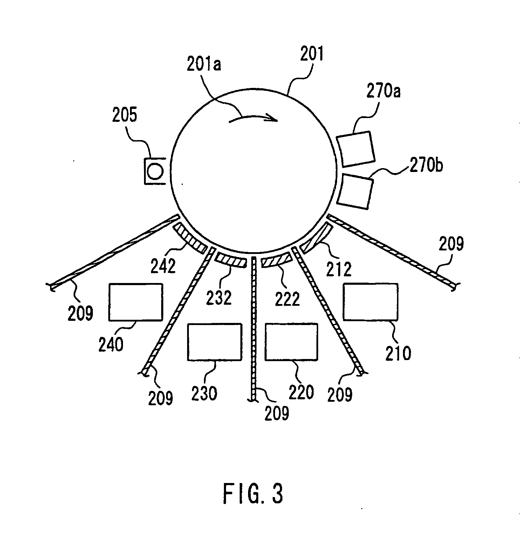

FIG. 3 is a schematic cross sectional view showing a configuration of an apparatus for manufacturing the thin film layered product 100. In FIG. 3, reference numeral 201 denotes a cylindrical can roller (carrier) that is rotated in a direction indicated by an arrow 201a. Further, reference numerals 270a and 270b denote patterning material application devices (patterning devices), and reference numeral 205 denotes a patterning material removing device. Further, reference numerals 210, 220, 230 and 240 denote a current collector layer forming device, a positive active material layer forming device, a solid electrolyte layer forming device and a negative active material layer forming device, respectively, which are arranged in space separated by partition walls 209 so as to face an outer peripheral face of the can roller 201. Open/close shutters 212, 222, 232 and 242 are arranged between each of the current collector layer forming device 210, the positive active material layer forming device 220, the solid electrolyte layer forming device 230 and the negative active material layer forming device 240 and the outer peripheral face of the can roller 201, respectively.

The apparatus having the above-described configuration is placed in a vacuum container (not shown) depressurized to a predetermined pressure.

The current collector layer forming device 210 is used to form the positive and negative current collector layers 111 and 115, and the positive active material layer forming device 220 is used to form the positive active material layer 112. Further, the solid electrolyte layer forming device 230 is used to form the solid electrolyte layer 113, and the negative active material layer forming device 240 is used to form the negative active material layer 114. Each of the devices is formed of, for example, a known vapor deposition device and allows materials used for the formation of the respective layers to evaporate. In this case, the shutters 212, 222, 232 and 242 that are mounted respectively between each of the devices and the can roller 201 are opened selectively, and thus only a particular layer can be formed on the outer peripheral face of the can roller 201.

The patterning material application devices 270a and 270b are used to allow a pattering material (oil) to adhere to predetermined regions on the outer peripheral face of the can roller 201. The oil is allowed to adhere on the outer peripheral face of the can roller 201 so as to form a predetermined shape before the thin films are formed respectively by the current collector layer forming device 210, the positive active material layer forming device 220, the solid electrolyte layer forming device 230 and the negative active material layer forming device 240. This allows the thin films to be prevented from being formed on the region to which the oil has adhered. Thus, the thin films each patterned into an arbitrary shape can be formed. This method is referred to as an oil patterning method.

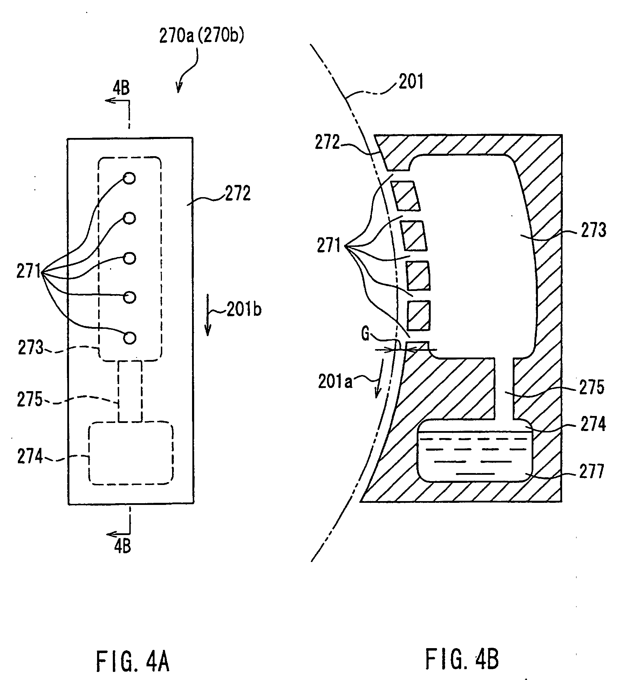

The patterning material application device 270a and the patterning material application device 270b have the same basic configuration. FIGs. 4A and 4B schematically show the configuration of the patterning material application devices (nozzles) 270a and 270b. FIG. 4A is a front view as seen from the side of the can roller 201, and FIG. 4B is a cross sectional view taken on line 4B - 4B of FIG. 4A. In FIG. 4A, an arrow 201b indicates a travel direction of the outer peripheral face of the can roller 201.

Each of the patterning material application devices 270a and 270b includes a storage reservoir 274 containing a liquid patterning material 277, and a cavity 273 containing the gasified patterning material. The storage reservoir 274 and the cavity 273 are connected by a connection duct 275. A plurality of micro-holes 271 (five in FIGs. 4A and 4B) connected to the cavity 273 are formed on an opposing face 272 facing the can roller 201. The plurality of micro-holes 271 are arranged substantially in parallel to the travel direction 201b of the outer peripheral face of the can roller 201, at equidistant spacing. The patterning material application devices 270a and 270b are heated to a temperature equal to or higher than the gasification temperature of the patterning material (oil) 277, the patterning material 277 in the storage reservoir 274 is vaporized, moved to the cavity 273, and emitted toward the outer peripheral face of the can roller 201 from the micro-holes 271. The emitted patterning material liquefies on the outer peripheral face of the can roller 201, forming a liquid film of the patterning material. By controlling the amount and temperature of the patterning material in the storage reservoir 274, the patterning material can be maintained so as to be emitted in a constant amount over time from the micro-holes 271.

In the manufacturing apparatus shown in FIG. 3, a pair of the patterning material application devices 270a and 270b are shifted back and forth in directions substantially parallel to a rotation axis direction of the can roller 201 (directions substantially at right angles to the travel direction 201b of the outer peripheral face of the can roller 201). Then, a plurality of stripes of the patterning material are formed on the outer peripheral face of the can roller 201 by the patterning material application device 270a, intersecting with a plurality of stripes of the patterning material formed on the outer peripheral face of the can roller 201 by the patterning material application device 270b.

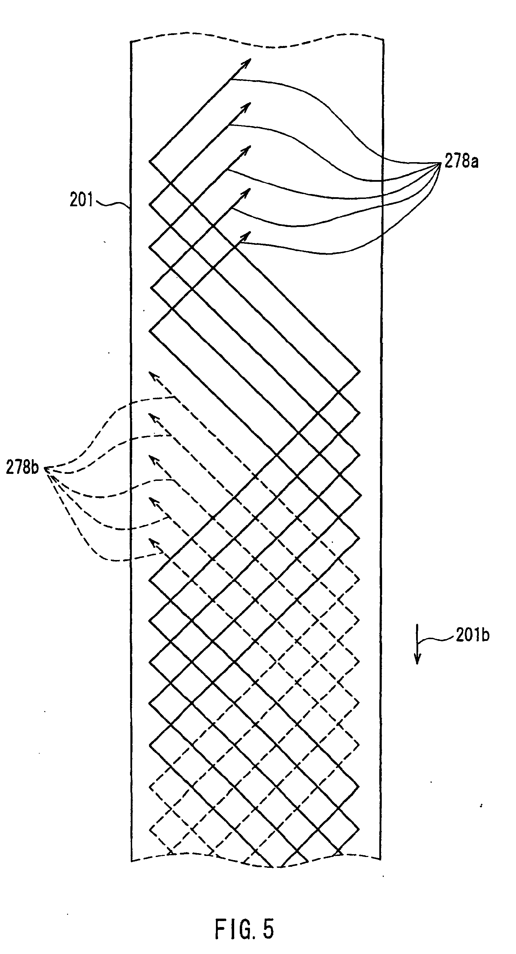

FIG. 5 is a development drawing of an example of a stripe pattern of a patterning material formed by the pair of the patterning material application devices 270a and 270b on the outer peripheral face of the can roller 201. The arrow 201b indicates the travel direction of the outer peripheral face of the can roller 201. A solid line 278a represents five stripes of the patterning material formed on the outer peripheral face of the can roller 201 by the patterning material application device 270a, and a dotted line 278b represents five stripes of the patterning material formed on the outer peripheral face of the can roller 201 by the patterning material application device 270b. As shown in the figure, by moving the pair of the patterning material application devices 270a and 270b back and forth while synchronizing them at a predetermined speed in a direction substantially parallel to the rotation axis direction of the can roller 201, it is possible to form a grid-shaped application pattern of the patterning material on the outer peripheral face of the can roller 201. Particularly, when the patterning material application devices 270a and 270b are moved at substantially the same speed as a speed at which the outer peripheral face of the can roller 201 travels, the stripes formed by the patterning material application devices 270a and 270b form an angle of substantially 45° with respect to the travel direction 201b. As a result, the grid-shaped application pattern can be attained, in which the stripes 278a and the stripes 278b intersect substantially at right angles.

Then, thin films are formed by any of the current collector layer forming device 210, the positive active material layer forming device 220, the solid electrolyte layer forming device 230, and the negative active material layer forming device 240. Since no thin film is formed in portions to which the patterning material has been applied, it is possible to form a multiplicity of rectangular thin films, each patterned into a grid-shape.

In addition, the patterning material application devices 270a and 270b are moved back and forth while being synchronized with the rotation of the can roller 201 so that after the can roller 201 is rotated for one turn, the grid-shaped pattern is formed in a position that substantially coincides with the position of the grid-shaped pattern formed the previous time. Thus, it is possible to laminate the rectangular thin films in order in the same position.

Vapor of the patterning material emitted from the micro-holes 271 is diffused while exhibiting directionality. Therefore, as shown in FIG. 4B, when a distance G between the micro-holes 271 and a surface on which the patterning material is allowed to adhere (the outer peripheral face of the can roller 201 in FIG. 4B) is increased, the stripes formed on the surface using the patterning material are increased in width. Therefore, for example, with the distance G set to a certain distance G1, a patterning material is allowed to adhere so as to form a grid-shape as shown in FIG. 5, and then a thin film is formed. Subsequently, with the distance G set to a distance G2 larger than the distance G1, the patterning material is allowed to adhere so as to form a grid-shape in substantially the same position as the position used last time to allow the patterning material to adhere, and then a thin film is formed. Thus, a rectangular thin film formed the second time can be formed so as to have an area smaller than that of a rectangular thin film formed the first time.

The patterning material removing device 205 removes an excess patterning material remaining unused on a surface of the can roller 201 after thin films are formed. There is no particular limit to a method of removing a patterning material, and the method can be selected according to a patterning material used or the like. For example, a patterning material can be removed by heating, for example, by light irradiation or the use of an electric heater, or by decomposition by plasma irradiation, ion irradiation or electron irradiation.

Next, a method for manufacturing the thin film layered product 100 described with regard to Embodiment 1 using the apparatus shown in FIG. 3 will be described in detail.

The thin film layered product 100 is formed by laminating the layers in order from bottom to top on the plane of FIG. 1. As described earlier, the layers of the same function (for example, the positive current collector layers 111) have a lamination area decreased in a direction from a lower layer toward an upper layer. This can be realized with the following condition. That is, when laminating a certain layer, the distance G between the micro-holes 271 of each of the patterning material application devices 270a and 270b and a surface on which a patterning material is allowed to adhere is required to be increased with increasing number of times the lamination is carried out.

Furthermore, as described earlier, the positive and negative current collector layers 111 and 115 are formed by the current collector layer forming device 210, and the positive active material layer 112 is formed by the positive active material layer forming device 220. Further, the solid electrolyte layer 113 is formed by the solid electrolyte layer forming device 230, and the negative active material layer 114 is formed by the negative active material layer forming device 240. That is, by the use of the four forming devices 210, 220, 230 and 240, the positive current collector layer 111, the positive active material layer 112, the solid electrolyte layer 113, the negative active material layer 114, the negative current collector layer 115, the negative active material layer 114, the solid electrolyte layer 113, and the positive active material layer 112 are laminated in this order. This can be realized with the following condition. That is, it is required to perform an operation for every rotation of the can roller 201, in which the shutter corresponding to the device for forming a layer to be formed is opened, and the other shutters are closed.

That is, for the manufacturing of the thin film layered product 100 using the apparatus shown in FIG. 3, it is required that the above-described distance G and opening and closing of the four shutters 212, 222, 232 and 242 be controlled precisely every time a layer is laminated.

For convenience, the distance G and an opening and closing state of the shutters in laminating each layer are expressed by reference characters "Gmn * Sm". In the reference characters, "Gmn" indicates, as shown in FIG. 4B, a distance between the micro-holes 271 and the surface on which a patterning material is allowed to adhere when applying the patterning material to form a certain layer. Further, "Sm" indicates the only shutter to be opened when forming the certain layer. Herein, "m" is a positive number selected from 1 to 4, and the numbers 1, 2, 3 to 4 correspond to the current collector layer forming device 210, the positive active material layer forming device 220, the solid electrolyte layer forming device 230, and the negative active material layer forming device 240, respectively. Further, "n" indicates a total number of times the device corresponding to the layer to be formed is used.

By the use of the above-mentioned reference characters "Gmn * Sm", the forming conditions of the thin film layered product 100 shown in FIG.1 can be described as follows.

Initially, the positive current collector layer 111a is formed. The positive current collector layer 111a is formed using the current collector layer forming device 210, and thus m = 1. Further, the positive current collector layer 111a is a layer formed on the first time using the current collector layer forming device 210, and thus n = 1. Accordingly, the condition regarding the distance G in forming the positive current collector layer 111a can be expressed as "G11". Further, in this case, it is required to open only the shutter 212 corresponding to the positive current collector layer forming device 210 and close the shutters other than the shutter 212. Therefore, the condition regarding the shutters can be expressed as "S1". Thus, the forming conditions in forming the positive current collector layer 111a can be expressed as "G11 * S1".

Next, the positive active material layer 112a is formed. The positive active material layer 112a is formed using the positive active material layer forming device 220, and thus m = 2. Further, the positive active material layer 112a is a layer formed on the first time using the positive active material layer forming device 220, and thus n = 1. Accordingly, the condition regarding the distance G in forming the positive active material layer 112a can be expressed as "G21". Further, in this case, it is required to open only the shutter 222 corresponding to the positive active material layer forming device 220 and close the shutters other than the shutter 222. Therefore, the condition regarding the shutters can be expressed as "S2". Thus, the forming conditions in forming the positive active material layer 112a can be expressed as "G21 * S2".

As for the other layers, the forming conditions "Gmn * Sm" for the respective layers can be expressed in the same manner.

The forming conditions for each of the layers constituting the deposition unit 110a in the lowest portion shown in FIG. 1 can be expressed in the order of forming the layers as follows:

| | |
|---|---|
| (1) Positive current collector layer 111a | G11 * S1 |
| (2) Positive active material layer 112a | G21 * S2 |
| (3) Solid electrolyte layer 113a | G31 * S3 |
| (4) Negative active material layer 114a | G41 * S4 |
| (5) Negative current collector layer 115a | G12 * S1 |
| (6) Negative active material layer 114b | G42 * S4 |
| (7) Solid electrolyte layer 113b | G32 * S3 |
| (8) Positive active material layer 112b | G22 * S2 |

The following description is made only for confirmation purposes. That is, the negative current collector layer 115a is formed using the current collector layer forming device 210, and thus m = 1. Further, the negative current collector layer 115a is a layer formed on the second time using the current collector layer forming device 210, and thus n = 2. Accordingly, the condition regarding the distance G in forming the negative current collector layer 115a can be expressed as "G12". Further, in this case, it is required to open only the shutter 212 corresponding to the current collector layer forming device 210 and close the shutters other than the shutter 212. Therefore, the condition regarding the shutters can be expressed as "S1". Thus, the forming conditions in forming the negative current collector layer 115a can be expressed as "G12 * S1".

After that, the deposition unit 110b to be laminated next is laminated. The forming conditions for each of the layers constituting the deposition unit 110b can be expressed in the order of forming the layers as follows:

| | |
|---|---|
| (9) Positive current collector layer 111b | G13 * S1 |
| (10) Positive active material layer 112c | G23 * S2 |
| (11) Solid electrolyte layer 113c | G33 * S3 |
| (12) Negative active material layer 114c | G43 * S4 |

(continued)

| (13) Negative current collector layer 115b | G14 * S1 |
| (14) Negative active material layer 114c | G44 * S4 |
| (15) Solid electrolyte layer 113c | G34 * S3 |
| (16) Positive active material layer 112c | G24 * S2 |

As for the layers in other deposition units to be laminated over the deposition unit 110b including the deposition unit 110c to be laminated next, the forming conditions for the respective layers also can be expressed in the same manner.

For the manufacturing of the thin film layered product 100 described with regard to Embodiment 1, preferably, the relationships expressed by the following Formulae 1 to 4 are satisfied. However, even if Formula 2 is not satisfied, the thin film layered product 100 shown in FIG. 1 can be manufactured.

$$\text{(Formula 1)} \qquad G11 < G12 < G13 < ...$$

$$\text{(Formula 2)} \qquad G21 < G22 < G23 < ...$$

$$\text{(Formula 3)} \qquad G31 < G32 < G33 < ...$$

$$\text{(Formula 4)} \qquad G41 < G42 < G43 < ...$$

As described above, the distance G is set when forming each of the layers using the current collector layer forming device 210, the solid electrolyte layer forming device 230, and the negative active material layer forming device 240 (preferably, further using the positive active material layer forming device 220), respectively. The distance G is increased with an increasing number of times the layers are formed using the corresponding device. As a result, each of the patterned thin films has an area decreased with an increasing number of times the lamination is carried out.

In this embodiment, using the device shown in FIG. 3, while the can roller 201 is rotated continuously, the distance G and the opening and closing state of the four shutters 212, 222, 232 and 242 are changed in synchronization with every rotation of the can roller 201.

In this manner, in the region divided into a grid of regions on the outer peripheral face of the can roller 201, a multiplicity of the thin film layered products 100 shown in FIG. 1 are formed, each having the shape of a quadrangular frustum.

The apparatus shown in FIG. 3 employs a method in which by gradually increasing the distance G, the stripes of a pattering material are increased in width gradually. However, the present invention is not limited thereto. For example, by gradually increasing the temperature of the patterning material, the strips also can be increased in width gradually. This is because with an increase in the temperature of the patterning material, an amount of vapor of the patterning material emitted from the micro-holes 271 is increased.

Furthermore, instead of allowing a patterning material to evaporate by heating, a so-called ink jet method can be used for allowing the patterning material to adhere. In the ink jet method, droplets of the liquid patterning material are emitted using a piezoelectric element. In this case, the width of the stripes of the patterning material also can be changed.

Moreover, instead of using the oil patterning method, a laser margin method also can be used. In the laser margin method, after forming each thin film, a laser beam is allowed to scan over the thin film so that the thin film is removed in the shape of a grid-shaped frame. A scanning condition of the laser beam is changed appropriately in synchronization with the rotation of the can roller 201, and thus the width of the grid-shaped frame in the shape of which the thin film is removed can be increased gradually.

(Embodiment 3)

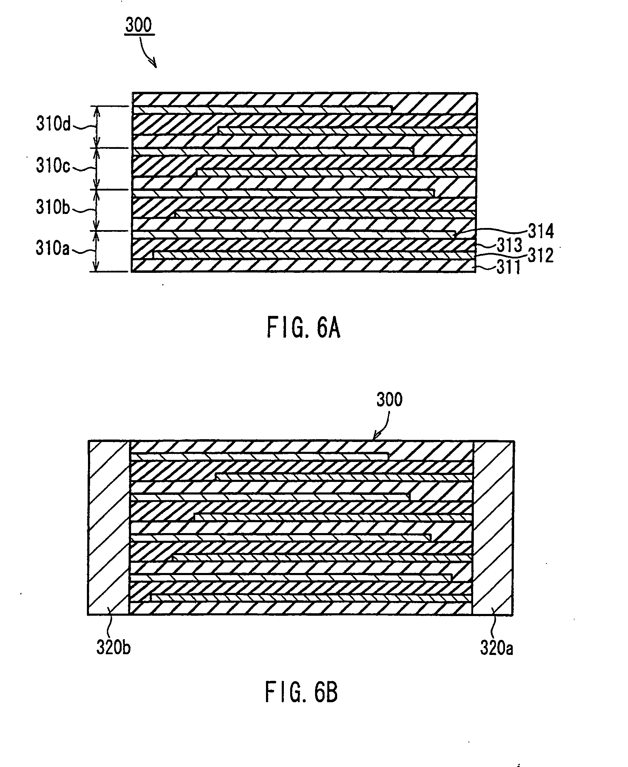

FIG. 6A is a schematic cross sectional view showing a configuration of a thin film layered product 300 according to Embodiment 3 of the present invention. FIG. 6B is a schematic cross sectional view showing a configuration of a capacitor using the thin film layered product 300.

As shown in FIG. 6A, the thin film layered product 300 according to this embodiment is composed of deposition units 310a, 310b, 310c, 310d and the like, which are laminated in this order from bottom to top. Each of the deposition units includes a first dielectric layer 311, a first electrode layer 312, a second dielectric layer 313, and a second electrode layer 314, which are provided from bottom to top. Each of the layers is substantially rectangular in plan shape (shape as viewed from a layering direction (vertical direction on the plane of FIG. 6A)).

Each of the layers is formed so as to have a predetermined rectangular plan shape by patterning. The first electrode layer 312 and the second electrode layer 314 are made of the same material. The first electrode layer 312 is exposed on one side face of the thin film layered product 300. The second electrode layer 314 is exposed on the other side face opposed to the one side face. Further, the first dielectric layer 311 and the second dielectric layer 313 are made of the same material and connected to each other in a portion in which either of the first and second electrode layers 312 and 314 is recessed to an inner side from the side face of the thin film layered product 300.

The first electrode layer 312 and the second electrode layer 314 has a lamination area (projected area of these layers along the layering direction) that is decreased in a direction from a lower layer toward an upper layer. That is, as for the first electrode layers 312, the first electrode layer 312 included in the deposition unit 310b laminated on the deposition unit 310a has a lamination area smaller than a lamination area of the first electrode layer 312 included in the deposition unit 310a. Further, the first electrode layer 312 included in the deposition unit 310c laminated on the deposition unit 310b has a lamination area smaller than the lamination area of the first electrode layer 312 included in the deposition unit 310b. The same applies to the second electrode layers 314.

In this configuration, the first dielectric layer 311 and the second dielectric layer 313 have substantially a constant lamination area.

According to this configuration, a large area of a region in which the first dielectric layer 311 and the second dielectric layer 313 are connected to each other can be secured, and thus a thin film layered product can be provided that has improved reliability of connection between layers and excellent properties in terms of preventing peeling between the layers and of moisture resistance.

As shown in FIG. 6B, a first external electrode 320a is formed on the side face of the thin film layered product 300, on which the first electrode layers 312 are exposed, so as to be connected electrically to the first electrode layers 312. Further, a second external electrode 320b is formed on the side face on which the second electrode layers 314 are exposed so as to be connected electrically to the second electrode layers 314. As a result, a capacitor can be formed that includes the first and second dielectric layers 311 and 313 as dielectric layers.

The first and second electrode layers 312 and 314 are made of, for example, a metal such as aluminum and have a thickness of about 0.04 μm. Further, the first and second dielectric layers 311 and 313 are formed of a thin film of STO, BTO or the like, an aluminum oxide, a silicon oxide, a titanium oxide or the like and have a thickness of about 0.2 μm. The number of the deposition units is, for example, 100.

The thin film layered product 300 having this configuration can be manufactured using an apparatus having the same configuration as that of the manufacturing apparatus described with regard to Embodiment 2 with reference to FIG. 3. That is, any one of the thin film forming devices 210, 220, 230 and 240 is used as an electrode layer forming device for forming the first and second electrode layers 312 and 314. One of the remaining devices is used as a dielectric layer forming device for forming the first and second dielectric layers 311 and 313, and the other two are left unused. Using the electrode layer forming device, for example, thin films of aluminum are formed by vapor deposition. Using the dielectric layer forming device, for example, electron beam vapor deposition (reactive vapor deposition) is performed using titanium while an oxygen gas is introduced. Each layer is patterned into one of a multiplicity of rectangular shapes by the grid-shaped pattern of a patterning material that has been applied beforehand by the patterning material application devices 270a and 270b. In this case, when patterning the first and second electrode layers 312 and 314, the above-described distance G between the micro-holes 271 and a surface on which the patterning material is allowed to adhere is increased with an increasing number of rotations of the can roller 201. As a result, as shown in FIG. 6A, a multiplicity of the thin film layered products 300 substantially in the shape of a rectangular solid can be formed on the outer peripheral face of the can roller 201. The thin film layered product 300 includes the first and second electrode layers 312 and 314 having a lamination area decreased in a direction from a lower layer toward an upper layer.

The first and second external electrodes 320a and 320b can be formed by thermal spraying of metal or the like.

In an example described above, the first dielectric layer 311 and the second dielectric layer 313 had substantially a constant lamination area. However, as in the thin film layered product 100 according to Embodiment 1, it also is possible to have a configuration in which a lamination area is decreased gradually in a direction from a lower layer toward an upper layer, so that a thin film layered product is formed into substantially the shape of a quadrangular frustum.

In this embodiment, although there is no particular limit to the number of the deposition units 310a, 310b, 310c, 310d and the like, the number is preferably 3 or higher, more preferably 10 or higher, most preferably 30 or higher so that a compact and high-capacity capacitor can be provided.

[Examples]

(Examples 1 to 4, Comparative Examples 1 to 4)

In Example 1, the thin film layered product 100 shown in FIG. 1 was manufactured using the apparatus shown in FIG. 3.

Stainless foil having a thickness of 30 μm was wrapped over the outer peripheral face of the cylindrical can roller 201 having a diameter of 500 mm. A fluorine-based releasing agent was sprayed beforehand on an outer surface of this stainless foil. While the can roller 201 was rotated at a circumferential speed of 10 m per minute, the thin film layered products 100 were formed on the stainless foil.

The positive and negative current collector layers 111 and 115 were formed of a nickel thin film having a thickness of 0.5 μm, and the positive active material layer 112 was formed of a Li-Co-O thin film having a thickness of 2 μm. Further, the solid electrolyte layer 113 was formed of a Li-P-O-N thin film having a thickness of 1 μm, and the negative active material layer 114 was formed of a Li thin film having a thickness of 2 μm. The positive and negative current collector layers 111 and 115 and the positive active material layer 112 were formed by an electron beam vapor deposition method, and the solid electrolyte layer 113 and the negative active material layer 114 were formed by a resistance heating vapor deposition method.

Prior to the forming of each thin film layer, oil was applied so as to form a grid shape by the patterning material application devices 270a and 270b. A fluorocarbon oil (trade name: "FOMBLIN"(manufactured by Ausimont (Deutschland) GmbH) was used as the oil. This oil was heated in the hermetically sealed storage reservoir 274, and vapor of the oil was emitted from the micro-holes 271 having an aperture diameter of 100 μm.

A rotational position of the can roller 201 was detected by a rotary encoder mounted in the can roller 201. Based on a detection signal obtained by the detection, the opening and closing of the shutters 212, 222, 232 and 242 and the distance G between the micro-holes 271 and a surface on which the patterning material was allowed to adhere were controlled. In this manner, thin films having a desired pattern were formed sequentially. The patterning material application devices 270a and 270b were allowed to move in directions parallel to the rotation axis direction of the can roller 201, and the moving speed thereof was set to substantially the same speed as the circumferential speed of the can roller 201. Two tracks in the form of stripes formed respectively by the application of the oil by the patterning material application devices 270a and 270b were orthogonal to each other, thereby allowing a grid-shaped oil pattern to be formed. In this case, the distance G was changed according to the type of a thin film to be formed. Further, when forming the same type of thin films, the distance G was increased with an increasing number of times the lamination is carried out with respect to the same type of thin films so that the stripes formed using the oil were increased in width. The stripes formed using the oil for forming the same type of thin films were set to have an amount of an increase in width (this corresponds with an amount of a decrease in length of one side of the rectangular thin film. Hereinafter, this amount is referred to as an "oil masking width change amount") of 20 μm each time lamination is carried out.

In this manner, a multiplicity of the thin film layered products 100 for battery use were formed on the stainless foil on the can roller 201. Each of the thin film layered products 100 had a lowest layer having sides of 20 mm in length and were composed of 100 deposition units. The multiplicity of the thin film layered products 100 substantially in the shape of a quadrangular frustum were arranged in directions orthogonal to each other.

After that, the above-mentioned stainless foil was removed from the can roller 201 and bent slowly so that the thin film layered products 100 of Example 1 were separated from the stainless foil.

In this manner, the thin film layered product 100 of Example 1 was obtained.

In each of Examples 2 to 4, a protective layer was formed on side faces of the above-described thin film layered product of Example 1.

With the use of a mask in which a multiplicity of apertures in the form of stripes were formed, the protective layer was formed only on inclined surfaces of the side faces of the thin film layered product while an upper face of the thin film layered product was masked. The apertures were arranged with a pitch corresponding to an arrangement pitch of the multiplicity of the thin film layered products that are the same as the thin film layered product of Example 1, formed on the stainless foil. First, the apertures in the form of stripes were arranged so as to coincide with one of the arrangement directions of the thin film layered products, thereby allowing the protective layer to be formed on one pair of the opposing side faces of each thin film layered product. Then, the mask was arranged so as to be rotated at an angle of 90 degrees, thereby allowing the protective layer to be formed on the other pair of the opposing side faces of each thin film layered products.

As the protective layer, in Examples 2 and 3, an acrylate resin layer of 2 μm thickness and an aluminum layer of 0.3 μm were formed in a vacuum by vapor deposition, respectively. Further, in Example 4, a SiO layer of 1 μm thickness was formed in a vacuum by sputtering.

In Example 2, the acrylate resin layer was formed by vapor deposition in the following manner. That is, an acrylic monomer was evaporated by heating at a temperature of 170°C and allowed to adhere to the side faces of the thin film layered product 100, and subsequently was subjected to irradiation of electron beams of 3 kV so as to cure.

In Example 3, the aluminum layer was formed by vapor deposition in the following manner. That is, a reactive vapor deposition method was used in which, while aluminum was evaporated by heating using electron beams of 10 kV, 200 sccm of oxygen gas was introduced into vapor of aluminum.

In Example 4, the SiO layer was formed by sputtering in the following manner. That is, with respect to a target of SiO, high-frequency sputtering was performed at a frequency of 13.56 MHZ. In this case, 50 sccm of oxygen gas was introduced so that the loss of oxygen inside the formed films can be prevented.

After forming the protective layer, in the same manner as in the case of Example 1, the thin film layered products of Examples 2 to 4 were separated from the stainless foil.

In this manner, the thin film layered products of Examples 2 to 4 with the protective layers were obtained.

In the same manner as in the cases of Examples 1 to 4, thin film layered products of Comparative Examples 1 to 4 were obtained. However, in these cases, the oil masking width change amount was set to 0 μm. The thin film layered product of Comparative Example 1 was substantially in the shape of a rectangular solid as shown in FIG. 7.

"A shaker test" was performed with respect to each of the above-described thin film layered products of Examples 1 to 4 and Comparative Examples 1 to 4. "The shaker test" was performed in the following manner.

That is, 100 randomly chosen samples of each thin film layered product were placed in a hermetically sealed cubic container having a volume of 0.001 m³, and the container was subjected to sine-wave oscillation of a frequency of 60 Hz and an amplitude of 30 mm in a horizontal plane for 90 seconds. Subsequently, the samples of the thin film layered product 100 were taken out of the container, and a rate of the occurrence of a short circuit (short-circuit failure rate) between a positive electrode and a negative electrode of the thin film layered product 100 was determined.

The results of the shaker test performed with regard to Examples 1 to 4 and Comparative Examples 1 to 4 are shown in Table 1.

Table 1

|  | Protective Layer | Short-Circuit Failure Rate (%) |
|---|---|---|
| Example 1 | (not provided) | 4 |
| Example 2 | acrylate resin | 1 |
| Example 3 | aluminum | 2 |
| Example 4 | SiO | 2 |
| Com. Example 1 | (not provided) | 10 |
| Com. Example 2 | acrylate resin | 4 |
| Com. Example 3 | aluminum | 7 |
| Com. Example 4 | SiO | 6 |

As can be seen from the results of the comparison between Example 1 and Examples 2 to 4 and the comparison between Comparative Example 1 and Comparative Examples 2 to 4, by forming the protective layer, the short-circuit failure rate could be improved.

The short-circuit failure rate of the thin film layered product of Example 1 without the protective layer was improved to a level equal to or higher than the short-circuit failure rate of each of the thin film layered products of Comparative Examples 2 to 4 with the protective layers.

When the protective layer was formed on the thin film layered product of Example 1, the short-circuit failure rate thereof further was improved.

Each of the above-described thin film layered products of Examples 1 to 4 and Comparative Examples 1 to 4 was obtained by being peeled from the stainless foil. For comparison, a thin film layered product having a lower layer on which stainless foil was left to adhere was obtained by cutting the stainless foil, and with respect to the thin film layered product, the shaker test was performed in the same manner. As a result, although the short-circuit failure rate had different values, it was confirmed that the same results as those shown in Table 1 were obtained qualitatively.

(Examples 5 to 8)

In the same manner as in the above-described case of Example 1, a multiplicity of the thin film layered products 100 were formed on stainless foil on the can roller 201. Then, a polyimide tape was attached to mask an upper face of each of the thin film layered products 100, thereby allowing a protective layer to be formed on side faces of each of the thin film layered products 100.

As the protective layer, in Example 6, an acrylate resin layer of 2 μm thickness was formed by vapor deposition in the same manner as in the case of Example 2. Further, in Example 7, a composite layer was formed in the following manner. That is, an acrylate resin layer of the same type as the layer used for Example 6 was formed by vapor deposition, and an aluminum layer of 0.3 μm thickness of the same type as the layer used for Example 3 further was formed on the acrylate resin layer. Further, in Example 8, ten of the composite layers of an acrylate resin and aluminum formed with regard to Example 7 were laminated.

After forming the protective layer, the polyimide tape for masking was removed by peeling. Then, by cutting the stainless foil, the thin film layered products, each having a lower face on which the stainless foil adhered, were obtained by separation.

As Example 5, in exactly the same manner as in the cases of Examples 6 to 8 except that no protective layer was formed, thin film layered products having a lower face on which stainless foil adhered were obtained.

Secondary batteries were manufactured using the above-described thin film layered products of Examples 5 to 8. In the secondary batteries, an upper face of each of the thin film layered products and a lower face opposed to the upper face, on which the stainless foil adhered were used as electrodes. With respect to the secondary batteries, "a reliability (moisture resistance) evaluation test" was performed in the following manner. That is, the secondary batteries were charged fully, and then the capacity-retaining ratio of each of the secondary batteries was determined after the secondary batteries were left standing for 168 hours in an atmosphere of 60°C and 90% RH.

The results of the reliability evaluation test performed with respect to Examples 5 to 8 are shown in Table 2.

Table 2

|  | Protective Layer | Capacity-Retaining Ratio (%) |
| --- | --- | --- |
| Example 5 | (not provided) | 30 |
| Example 6 | acrylate resin (one layer) | 35 |
| Example 7 | composite layer (single layer) | 60 |
| Example 8 | composite layer (10 layers) | 90 |

As shown in Table 2, the capacity-retaining ratio was higher in the order of Examples 5, 6, 7 and 8. This indicates that the moisture resistance and the reliability as the secondary batteries of Examples 5, 6, 7 and 8 are increased in this order.

Conceivably, the moisture resistance was improved with the increasing number of thin films constituting the protective layer because of the following two reasons. First, the respective positions of physical defects such as pinholes that are caused inevitably in forming the thin films are shifted with respect to each other by forming the thin films into a multilayer structure and thus are made discontinuous, thereby suppressing water penetration. Secondly, a stress remaining inside each thin film is relieved by heating in forming another thin film on the thin film, thereby suppressing the occurrence of mechanical defects attributable to the stress such as a crack, peeling of the layers and the like.

Secondary batteries were manufactured using the above-described thin film layered products of Examples 6 to 8. In each of the thin film layered products, as the protective layer, an epoxy resin was used in place of an acrylate resin. With respect to the secondary batteries, the reliability evaluation test was performed, and the same results were obtained.

Furthermore, in place of the aluminum vapor deposited film constituting the above described protective layer, a metal thin film of nickel, copper, titanium, tantalum, cobalt, gold, silver, platinum or the like may be used.

Furthermore, as the protective layer, instead of using a resin film of, for example, an acrylate resin, an oxide thin film of metal or semimetal also can be used.

Moreover, the protective layer also may be formed only of an insulating film of an oxide or a nitride of metal or semimetal.

The embodiments disclosed in this application are intended to illustrate the technical aspects of the invention and not to limit the invention thereto. The invention may be embodied in other forms without departing from the spirit and the scope of the invention as indicated by the appended claims and is to be broadly construed.

**Claims**

1. A thin film layered product comprising at least two deposition units, each of which includes at least a first thin film layer and a second thin film layer,

   wherein at least one of the first thin film layer and the second thin film layer in each of the at least two deposition units has an area decreased in a direction from a lower layer toward an upper layer.

2. The thin film layered product according to claim 1,
wherein the thin film layered product has substantially the shape of a trapezoid in cross section along a layering direction.

3. The thin film layered product according to claim 1,
wherein the first thin film layers and/or the second thin film layers in the at least two deposition units are connected electrically to each other.

4. The thin film layered product according to claim 1,
wherein each of extraction electrodes connected electrically to the first thin film layers and the second thin film layers in the at least two deposition units, respectively, is formed in at least a portion on a face other than both end faces in a layering direction.

5. The thin film layered product according to claim 1,
wherein a protective layer is provided in at least a portion on a face other than both end faces in a layering direction.

6. The thin film layered product according to claim 1,
wherein each of the first thin film layer and the second thin film layer is substantially rectangular in plan shape.

7. A thin film battery comprising at least two deposition units, each of which includes at least a current collector layer, a positive active material layer, a solid electrolyte layer, and a negative active material layer,
wherein at least one of the current collector layer, the positive active material layer, the solid electrolyte layer, and the negative active material layer in each of the at least two deposition units has an area decreased in a direction from a lower layer toward an upper layer.

8. A capacitor comprising at least two deposition units, each of which includes at least a dielectric layer and an electrode layer,
wherein at least one of the dielectric layer and the electrode layer in each of the at least two deposition units has an area decreased in a direction from a lower layer toward an upper layer.

9. A method for manufacturing a thin film layered product comprising by taking as one unit: a step of laminating a first thin film layer patterned into a predetermined shape; and a step of laminating a second thin film layer patterned into a predetermined shape, the unit of steps being performed repeatedly on a carrier, whereby the thin film layered product is manufactured that is composed of at least two deposition units, each of which includes at least the first thin film layer and the second thin film layer,
wherein at least one of the first thin film layer and the second thin film layer in each of the at least two deposition units is laminated so as to have an area decreased with an increasing number of times the lamination is carried out.

10. The method according to claim 9,
wherein before each of materials of the first thin film layer and the second thin film layer is deposited, oil is applied in a predetermined region, whereby each of the first thin film layer and the second thin film layer is pattered into a predetermined shape.

11. The method according to claim 10,
wherein at least one of an area in which the oil is applied before the material of the first thin film layer is deposited and an area in which the oil is applied before the material of the second thin film layer is deposited is increased with increasing number of times the lamination is carried out.

12. The method according to claim 10,
wherein the oil is applied using at least one pair of nozzles, each of which has micro-holes arranged so as to be opposed to the carrier, and
while the carrier is allowed to travel in one direction, each of the nozzles is allowed to move back and forth in directions substantially orthogonal to the one direction in which the carrier is allowed to travel so that tracks formed on the carrier by the micro-holes of one of the nozzles and tracks formed on the carrier by the micro-holes of the other of the nozzles intersect each other.

13. The method according to claim 12,
    wherein at least one of the first thin film layer and the second thin film layer is patterned by applying the oil in such a manner that a distance between a surface on which the oil is allowed to adhere and the micro-holes is increased with increasing number of times the lamination is carried out.

14. An apparatus for manufacturing a thin film layered product, comprising:

    a rotating carrier;
    a first thin film layer forming device that is opposed to the carrier and allows a material of a first thin film layer to be deposited on a surface of the carrier;
    a second thin film layer forming device that is opposed to the carrier and allows a material of a second thin film layer to be deposited on the surface of the carrier; and
    a patterning device that is opposed to the carrier and patterns each of the first thin film layer and the second thin film layer into a predetermined shape,

    wherein the patterning device performs patterning with respect to at least one of the first thin film layer and the second thin film layer so that the at least one of the first thin film layer and the second thin film layer has an area decreased with an increasing number of rotations of the carrier.

15. The apparatus according to claim 14,
    wherein the patterning device is an oil application device that is arranged on an upstream side of the first thin film layer forming device and the second thin film layer forming device in a rotation direction of the carrier.

16. The apparatus according to claim 15,
    wherein the oil application device includes at least one pair of nozzles in each of which micro-holes are arranged, and each of the nozzles in a pair is allowed to move so that tracks formed on the carrier by the micro-holes of one of the nozzles in the pair and tracks formed on the carrier by the micro-holes of the other of the nozzles in the pair intersect each other.

17. The apparatus according to claim 16,
    wherein when at least one of the first thin film layer and the second thin film layer is patterned, oil is applied in such a manner that a distance between a surface on which the oil is allowed to adhere and the micro-holes is increased in synchronization with rotation of the carrier.

FIG. 1

FIG. 2

FIG. 3

270a (270b)

FIG. 4A

FIG. 4B

201

278a

278b

201b

FIG. 5

FIG. 6A

FIG. 6B

900

915b
911b

912b
913b
914b
915a
910a
914a
913a
912a
911a

FIG. 7

## INTERNATIONAL SEARCH REPORT

| International application No. |
|---|
| PCT/JP03/03543 |

| A. CLASSIFICATION OF SUBJECT MATTER |
|---|
| Int.Cl⁷ B32B3/02, H01M10/40, H01G9/155 |

According to International Patent Classification (IPC) or to both national classification and IPC

| B. FIELDS SEARCHED |
|---|

Minimum documentation searched (classification system followed by classification symbols)

Int.Cl⁷ B32B1/00-35/00, H01M10/00-10/34, H01G9/00-9/24,
B05D7/1/00-7/26, C23C14/00-14/58, C23C18/00-20/08

Documentation searched other than minimum documentation to the extent that such documents are included in the fields searched

| Jitsuyo Shinan Koho | 1926-1996 | Toroku Jitsuyo Shinan Koho | 1994-2003 |
|---|---|---|---|
| Kokai Jitsuyo Shinan Koho | 1971-2003 | Jitsuyo Shinan Toroku Koho | 1996-2003 |

Electronic data base consulted during the international search (name of data base and, where practicable, search terms used)

| C. DOCUMENTS CONSIDERED TO BE RELEVANT |
|---|

| Category* | Citation of document, with indication, where appropriate, of the relevant passages | Relevant to claim No. |
|---|---|---|
| X | US 2001/0005561 A1 (Kazuo YAMADA, Takehito MITATE, Motoaki NISHIJIMA), 28 July, 2001 (28.07.01), Figs. 1, 2 & JP 2001-167743 A | 1-7 |
| X | JP 04-201330 A (Hitachi, Ltd.), 30 November, 1992 (30.11.92), Fig. 6 (Family: none) | 1-9 |
| X | JP 2001-328199 A (Bridgestone Corp.), 27 November, 2001 (27.11.01), Fig. 1 (Family: none) | 1-9 |

☒ Further documents are listed in the continuation of Box C.  ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier document but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 27 June, 2003 (27.06.03) | 15 July, 2003 (15.07.03) |

| Name and mailing address of the ISA/ | Authorized officer |
|---|---|
| Japanese Patent Office | |
| Facsimile No. | Telephone No. |

Form PCT/ISA/210 (second sheet) (July 1998)

## INTERNATIONAL SEARCH REPORT

International application No.

PCT/JP03/03543

| C (Continuation). DOCUMENTS CONSIDERED TO BE RELEVANT | | |
|---|---|---|
| Category* | Citation of document, with indication, where appropriate, of the relevant passages | Relevant to claim No. |
| Y<br>A | JP 2000-144375 A  (Toray Industries, Inc., Toyo Metallizing Co., Ltd.), 26 May, 2000 (26.05.00), (Family: none) | 9,10,14,15<br>11-13,16 |

Form PCT/ISA/210 (continuation of second sheet) (July 1998)